# EUROPÄISCHE PATENTSCHRIFT

(11) **EP 1 521 110 B1**
(45) Veröffentlichungstag und Bekanntmachung des Hinweises auf die Patenterteilung: **01.03.2006**
(21) Anmeldenummer: 04021814.1
(22) Anmeldetag: 14.09.2004
(51) Int. Cl.: G02B 27/48, G02B 27/09, G02B 5/30, G03F 7/20, H01S 3/00

(54) **Kohärenzminderer**
Device for reducing the optical coherence
Dispositif pour réduire la cohérence optique

(30) Priorität: 01.10.2003 DE 10345784
(43) Veröffentlichungstag der Anmeldung: 06.04.2005
(73) Patentinhaber: Carl Zeiss SMS GmbH, 07745 Jena (DE)
(72) Erfinder: Hollemann, Susanne, Dr., 07749 Jena (DE); Engel, Thomas, Dr., 99102 Erfurt OT Niedernissa (DE)
(74) Vertreter: Geyer, Fehners & Partner

(56) Entgegenhaltungen:
- WO-A-99/64916
- DE-A- 10 201 315
- DE-A- 19 508 754

## Beschreibung

Die Erfindung bezieht sich auf einen Kohärenzminderer, der mindestens ein doppelbrechendes Element aufweist, welches ein zugeführtes, kohärentes Strahlbündel in mehrere in senkrecht zueinander liegenden Polarisationsrichtungen polarisierte Teilstrahlbündel so aufteilt, daß die Teilstrahlbündel zueinander in Strahlrichtung und/oder quer zur Strahlrichtung versetzt sind und/oder in unterschiedliche Richtungen propagieren.

Für Anwendungen, bei denen monochromatische Strahlungen geringer Bandbreite benötigt wird, setzt man üblicherweise Strahlung aus Laser-Lichtquellen ein. Dies ist beispielsweise bei Mikroskopen, mit denen in der Halbleiterfertigung verwendete Masken inspiziert werden, bei der Waferinspektion oder bei Laserprojektionssystemen der Fall. Bei Lasem als Lichtquellen in einer Beleuchtungsanordnung kommen jedoch kohärente Störungen zum Tragen, die in Form sogenannter Speckle auftreten.

Speckle entstehen durch die Interferenz kohärenter Teilwellenzüge eines Lichtbündels bei der Superposition in der Beobachtungsebene. Diese Interferenzerscheinungen können ebenso wie ein inhomogenes Strahlprofil eines beleuchtenden Strahls zu einer inhomogenen Objektbeleuchtung führen. Speckle stellen somit kohärentes Rauschen dar, das im Endeffekt den möglichen Dynamikbereich für nutzbare Information und damit den in der Beobachtungsebene maximal erzielbaren Bildkontrast herabsetzt. Um dies zu vermeiden und um den in einer Beobachtungsebene erzielbaren maximalen Bildkontrast in Form eines Nutzsignals zu steigern, möchte man deshalb den Speckle Kontrast in der Beobachtungsebene soweit wie möglich reduzieren. Dazu kommen die eingangs erwähnten Kohärenzminderer zum Einsatz, um die Kohärenz eines Strahlenbündels, insbesondere eines Beleuchtungsstrahlenbündels soweit zu verringern, daß unerwünschte Interferenzerscheinungen und Speckl im Objektfeld nicht auftreten.

Ein Kohärenzminderer der eingangs genannten Art ist in der DE 102 01 315 A1 beschrieben, die doppelbrechende Elemente zur Kohärenzminderung einsetzt. Gemäß dem dort beschriebenen Konzept wird die Kohärenzlänge der Strahlung nicht verändert, sondern stattdessen mittels Doppelbrechungseffekten ein kohärenter Wellenzug in mehrere zueinander inkohärente umgesetzt, so daß die dadurch erhaltene Strahlung der Strahlung aus mehreren (identischen) Strahlquellen entspricht, die jeweils in ihren Eigenschaften der Strahlquelle, aus der das Ausgangsstrahlbündel stammt, gleichen, jedoch nicht mehr zueinander interferenzfähige Strahlung liefern. Die Teilstrahlbündel, aus der die Beleuchtungsstrahlung dann zusammengesetzt ist, sind zeitlich oder räumlich zueinander verschoben.

Der in der DE 102 01 315 A1 beschriebene Aufbau sieht mehrere hintereinander im Strahlengang liegende doppelbrechende Elemente vor, die jeweils vollständig vom Strahlbündel durchleuchtet werden und durch doppelbrechende Effekte die Aufteilung in Teilstrahlbündel bewirken. Um bei einer schmalbandigen und damit hochkohärenten Ausgangsstrahlung eine bestimmte Kohärenzminderung zu erreichen, sieht die DE 102 01 315 A1 eine Vielzahl von hintereinander geschalteten doppelbrechenden Elementen vor, was zu einer gewissen Mindestbaugröße des Kohärenzminderers führt.

Der Erfindung liegt deshalb die Aufgabe zugrunde, einen Kohärenzminderer der eingangs genannten Art so weiterzubilden, daß ein kompakter Aufbau erzielt wird.

Diese Aufgabe wird mit einem Kohärenzminderer der eingangs genannten Art dadurch gelöst, daß das doppelbrechende Element einen Stapel aus doppelbrechenden Platten aufweist, wobei die einzelnen Platten optisch unterschiedlich lang sind und jeweils nur von einem der Teilstrahlbündel durchsetzt sind.

Erfindungsgemäß wird also im Kohärenzminderer mindestens ein Stapel aus doppelbrechenden Platten verwendet, wobei die Platten unterschiedlich lang sind. Die Schmalseiten der Platten dienen als Eintritts- bzw. Austrittsflächen und die Strahlung propagiert im wesentlichen senkrecht zur Oberflächennormalen der Platte. Der einfallende Strahl wird also durch den Stapel aus doppelbrechenden Platten in streifenförmige Teilstrahlbündel zerlegt, die durch den doppelbrechenden Effekt zueinander in Strahlrichtung und/oder quer zur Strahlrichtung versetzt sind und/oder in unterschiedliche Richtungen propagieren, je nach Ausbildung der Eintritts- und Austrittsflächen der Platten. Die Unterschiedlichkeiten der einzelnen Teilstrahlbündel liegt weiter darin, daß sie unterschiedliche optische Wege beim Passieren der Platten des Stapels durchlaufen, da die Platten unterschiedlich lang sind. Zusätzlich zu der beispielsweise aus der US 6.069.739 bekannten unterschiedlichen Phasenverschiebung aufgrund der verschiedenen Plattenlängen tritt die doppelbrechende Wirkung jeder Platte ein, so daß sich ein Kombinationseffekt einstellt.

Das aus dem Stapel austretende Strahlbündel weist dadurch streifenförmige Zellen mit unterschiedlichen Strahleigenschaften auf. Je nach Lage der optischen Achse des doppelbrechenden Materials einer Platte beziehungsweise der Winkel unter denen die Ein- und Austrittsflächen der Platten zur optischen Achse liegen, kann es sich bei den optischen Eigenschaften dabei um die Ausbreitungsrichtung, einen Versatz quer zur Strahlrichtung oder eine Phasenverschiebung handeln.

Zur Kohärenzminderung kann je nach Beleuchtungsanforderung ein einziger Stapel aus doppelbrechenden Platten genügen. Eine besonders große Kohärenzminderung erhält man, wenn zwei zueinander gekreuzte Stapel aus doppelbrechenden Platten verwendet werden, so daß in der Durchsicht ein Raster entsteht. Die erwähnten streifenförmigen Zellen sind dann zusätzlich durch den zweiten gekreuzten Stapel weiter unterteilt, so daß im Endeffekt im Querschnitt quadratische oder rechteckige, beziehungsweise rautenförmige oder parallelogrammförmige Zellen entstehen. Unter Raster wird dabei jede regelmäßige Anordnung der Zellen verstanden, z.B. auch eine hexagonale Struktur.

Zweckmäßigerweise wird man die optische Länge der Platten sowie die Ausrichtung der optisch aktiven Achsen so wählen, daß benachbarte Zellen, d. h. benachbarte Teilstrahlbündel des Strahlbündels um mindestens eine zeitliche Kohärenzlänge getrennt sind (Unter zeitlicher Kohärenzlänge wird dabei, wie in diesem Fachgebiet üblich, die Kohärenzlänge in Ausbreitungsrichtung der Strahlung verstanden). Eine Übereinstimmung in den optischen Weglängen, die die Teilstrahlbündel zweier Zellen durchliefen, sollte vorzugsweise nur dann auftreten, wenn der geometrische laterale Abstand dieser Zellen größer ist als die räumliche Kohärenzlänge (Unter räumlicher Kohärenzlänge wird dabei, wie üblich, die Kohärenzlänge quer zur Strahlausbreitungsrichtung verstanden). Erfüllt man diese Anforderungen, ist eine Interferenz zwischen benachbarten Teilstrahlbündeln bei der Beleuchtung verhindert. Die unterschiedlichen optischen Wege werden dabei durch die verschiedenen Summen der optischen Wege erreicht, die jedes Teilstrahlenbündel in den beiden doppelbrechenden Platten und dem zugehörigen Luftweg für eine Zelle zurücklegte.

Eine besonders homogene Beleuchtung eines Objektes ist zu erreichen, wenn den mindestens zwei Stapeln aus doppelbrechenden Platten ein weiteres Homogenisierungselement nachgeordnet ist, das Optikelemente in einer zum Raster passenden Anordnung aufweist. Als weiteres Homogenisierungselement kommt insbesondere ein Stufenspiegelarray, ein Faserbündel, ein Mikroskopspiegel- oder Mikrolinsenarray in Frage. Es ist natürlich an das Raster, mit dem die eingangs erwähnten Zellen angeordnet sind, angepaßt. Bei einem Mikrolinsenarray kann es sich um ein klassisches, kubisch angeordnetes Gitter aus Mikrolinsen handeln; natürlich ist auch jede andere geometrische Anordnung zum Beispiel in Form eines hexagonalen Wabenkondensors, anwendbar, wenn die Anzahl und Anordnung von Plattenstapeln dies erfordert. Die Dichte des durch die doppelbrechenden Plattenstapel bewirkten Rasters sollte dabei gleich oder größer als die Rasterdichte des weiteren Homogenisierungselementes sein.

Durch ein solches Mikrolinsenarray, das nachfolgend exemplarisch für ein Homogenisierungselement steht, wird einerseits das Strahlprofil räumlich durchmischt. Die räumliche Überlagerung der Bilder aller Mikrolinsen des Mikrolinsenarrays in einer Feldebene führt andererseits zur Reduktion der Speckle in der Objektebene, was eine homogene Beleuchtung gewährleistet. Dabei ist in der Pupille jeder Mikrolinse eine kleine beleuchtete Fläche erzeugt. Durch die vorgeordneten Stapel aus doppelbrechenden Platten ist nun die Punktdichte in der Pupille jeder Mikrolinse besonders hoch, ohne daß das Mikrolinsenarray verändert werden müßte. Dies verbessert die Homogenisierungswirkung des Mikrolinsenarrays. Der erfindungsgemäße Kohärenzminderer nutzt den doppelbrechenden Effekt also wahlweise zur Minderung der Interferenzfähigkeit oder zur Erhöhung der Homogenität der Bildfeldausleuchtung.

Der Abstand der Mikrolinsen in Mikrolinsenarray ist vorzugsweise passend zur Dicke der Platten im Stapel, so daß jede der eingangs erwähnten Zellen genau einer Mikrolinse zugeordnet ist. Ein durch den Durchgang durch die beiden Stapel erzeugtes Teilstrahlbündel kann dann genau eine Mikrolinse speisen. Dies muß aber nicht so sein: Eine weitere Zerlegung mittels dichter gepackter Mikrolinsen ist genauso möglich, wie mehrere Teilstrahlbündel in einer Mikrolinse zusammenzuführen. Vorzugsweise erfolgt dazu eine Abbildung durch eine möglicherweise vergrößernde oder verkleinernde Abbildungsanordnung, die beispielsweise aus mehreren teleskopischen 4f-Abbildungen zusammengesetzt ist.

Zur Beleuchtung ist es zweckmäßig, die vom Mikrolinsenarray ausgehenden Strahlbündel zur homogenen Ausleuchtung eines Objektfeldes mittels einer Beleuchtungsoptik weiterzuleiten. Die Beleuchtungsoptik kann beispielsweise in Form eines Kondensors ausgebildet werden.

Der Einfall der Strahlung auf einen Stapel doppelbrechenden Platten kann im einfachsten Fall senkrecht erfolgen. Es besteht auch die Möglichkeit für nichtsenkrechten Einfall. Durch geeignete Wahl der optisch aktiven Achse des doppelbrechenden Materials der Platten in der Eintrittsfläche erfolgt eine Zerlegung in außerordentlichen und ordentlichen Teilstrahl, die beide gleiche Intensität haben. Vorzugsweise ist die optisch aktive Achse im 45° Winkel zur einer möglichen Polarisationsrichtung der einfallenden Strahlung orientiert. Die Länge jeder Platte in durchstrahlter Richtung wird vorzugsweise so gewählt, daß der optische Wegunterschied zwischen ordentlichen und außerordentlichen Teilstrahlen mindestens der zeitlichen Kohärenzlänge entspricht. Das verhindert Interferenzen zwischen den Teilstrahlen, die ansonsten nach dem Durchgang durch die zweite Platte auftreten könnte.

Um die Teilstrahlen in unterschiedliche Richtungen abzustrahlen beziehungsweise gegeneinander zu versetzen, ist es möglich die Ein- oder Austrittsfläche jeder Platte in einem Winkel zur optischen Achse zu halten. Dadurch propagieren außerordentlicher und ordentlicher teilstrahl, die senkrecht zueinander polarisiert sind, beim Austritt aus der Platte in unterschiedliche Richtungen. Der Keilwinkel, in dem die Ein- oder Austrittsfläche gegenüber der optischen Achse der Platte liegt, ist dabei in der Regel so zu wählen, daß dafür gesorgt ist, daß die beiden zueinander gehörigen Teilstrahlen so auf den zweiten Plattenstapel treffen, daß sich nach Durchlauf durch den zweiten Stapel das oben erwähnte Raster der Teilstrahlen ergibt. Gegebenenfalls ist dabei eine Abbildung zwischen ersten und zweiten Plattenstapel vorzusehen.

Variiert man den Keilwinkel innerhalb eines Stapels, erhält man eine zusätzliche Kohärenzminderung. Eine weitere Zerlegung der vom ersten Plattenstapel abgegebenen Vielzahl von Teilstrahlen erreicht man, wenn die Orientierung der optisch aktiven Achse in der Eintrittsfläche des zweiten Stapels gegenüber der des ersten Stapels gedreht ist. Bei einer Drehung um 45° erhält man eine Verdopplung der Teilstrahlen mit jeweils gleicher Intensität der Teilstrahlen. Die Teilstrahlen können gegeneinander versetzt sein und/oder hinsichtlich ihrer Propagationsrichtung eine Winkeldivergenz zueinander aufweisen.

Ist die optische Weglängendifferenz in einem Stapel benachbarter Platten größer oder gleich der zeitlichen Kohärenzlänge, ist die Interferenzfähigkeit benachbarter Zellen, d. h. benachbarter Teilstrahlbündel vermindert.

Die Erfindung wird nachfolgend unter Bezugnahme auf die Zeichnungen beispielhalber noch näher erläutert. In den Zeichnungen zeigt
- Fig. 1: eine schematische Ansicht einer ersten Ausführungsform einer Beleuchtungsanordnung mit einem Kohärenzminderer,
- Fig. 2: eine schematische Darstellung der Wirkung eines Plattenstapels in Kohärenzminderer der Figur 1,
- Fig. 3: eine erste Ausführungsform zur Veranschaulichung der Aufteilung eines Strahlbündels zueinander in kohärente Teilstrahlbündel und
- Fig. 4: eine zweite Ausführungsform ähnlich der Figur 3.

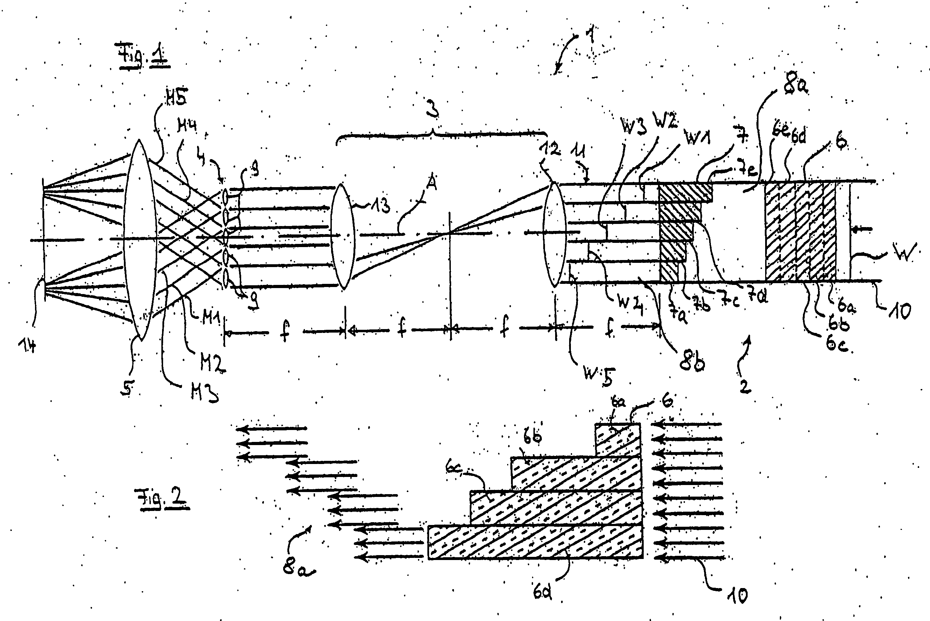

Fig. 1 zeigt einen Kohärenzminderer 1 für eine Beleuchtungsanordnung eines Mikroskops, der eine Plattenstapeleinheit 2, eine dieser nachgeördnete 4f-Abbildungsoptik 3, ein darin eingebundenes Mikrolinsenarrays 4 sowie eine Kondensoroptik 5 aufweist, die Beleuchtungsstrahlung abgibt.

Die Plattenstapeleinheit 2 ist aus zwei Plattenstapeln 6, 7 aufgebaut, wobei jeder Plattenstapel aus mehreren gestapelten Platten 6a-e, 7a-e aus doppelbrechendem Material aufgebaut ist. Der Plattenstapel 6 ist gegenüber dem Plattenstapel 7 um 90° gekreuzt, d. h. die Platten 6a-e des Stapels 6 sind parallel zur Zeichenebene der Fig. 1 aufgestapelt, wo hingegen die Platten 7a-e senkrecht zur Zeichnungsebene aufeinander gelegt sind. Der Plattenstapel 6 gibt ein gemischtes Strahlbündel 8a ab, das vom Plattenstapel 7 weiter zerlegt wird, so daß nach der Plattenstapeleinheit 2 ein phasengemischtes Strahlbündel 8b vorliegt.

Der Plattenstapel 6 weist so viele Platten auf, wie in der Stapelrichtung des Plattenstapels 6 (senkrecht zur Zeichnungsebene) Mikrolinsen 9 im Mikrolinsenarray 4 vorgesehen sind. Gleiches gilt hinsichtlich des Plattenstapels 7, der exakt so viele Platten 7a-e enthält, wie es Mikrolinsen 9 senkrecht zur Stapelrichtung des Plattenstapels 7 (parallel zur Zeichnungsebene) gibt. (Alternativ kann der zweite Plattenstapel 7 auch ein Mehrfaches an Platten aufweisen). In einer Ausführungsform ist das Mikrolinsenarray 4 zirka 3 x 6 mm² und der Durchmesser einer Mikrolinse 9 beträgt cirka 150 µm. Die Platten der Plattenstapel 6, 7 sind aufeinander geschichtet und zur Halterung geklemmt.

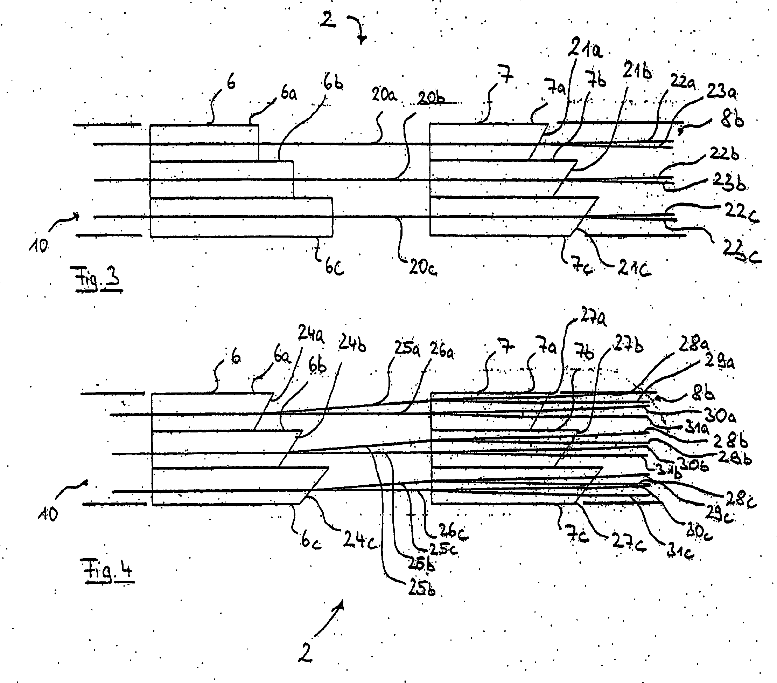

Wie aus Fig. 1 ersichtlich ist, trifft ein kohärentes (oder partiell kohärentes) Strahlbündel 10 aus einer (nicht dargestellten) Laserstrahlungsquelle, z.B. mit einer Wellenlänge von 193 nm, auf die Plattenstapeleinheit 2 und wird dadurch in ein Teilstrahlbündel zerlegt. Dies ist in Fig. 2 anhand des Plattenstapels 6 exemplarisch dargestellt. Das einfallende Strahlenbündel 10 mit einer einheitlichen Wellenfront W wird durch die unterschiedlichen optischen Längen der einzelnen Platten 6a-6d (in Vereinfachung ist in Fig. 2 ein Stapel mit vier Platten 6a-d dargestellt) und wird durch die unterschiedliche optische Weglänge, die die einzelnen Platten aufweisen, zeitlich unterschiedlich verzögert, so daß für jede Platte 6a-d ein Teilstrahlbündel austritt.

Die optisch aktive Achse des doppelbrechenden Materials jeder Platte 6a-d des Plattenstapels 6 liegt zusätzlich in einem Winkel von 45° zur linearen Polarisationsrichtung des einfallenden Strahlenbündels 10, so daß jedes Teilstrahlbündel des gemischten Strahlenbündels 8a sich noch einmal aus einem Teilstrahlbündelpaar zusammensetzt, das sich durch die unterschiedlichen optischen Weglängen für ordentlichen und außerordentlichen Teilstrahl im doppelbrechenden Material unterscheidet und senkrecht zueinander polarisiert ist. Die vier zeitlich durch die unterschiedliche Länge der Plattenstapel verzögerten Teilstrahlen im gemischten Strahlbündel 8a sind somit noch einmal hinsichtlich ihrer Polarisation unterteilt, so daß insgesamt acht Teilstrahlbündel vorliegen. Mit anderen Worten, das in Fig. 2 schematisch gezeigte gemischte Strahlbündel 8a besteht aus zwei Gruppen mit je vier Teilstrahlbündeln, wobei die Teilstrahlbündel jeder Gruppe gegeneinander durch die unterschiedliche geometrische Länge der Platten versetzt sind und die Gruppen sich hinsichtlich ihrer Polarisation unterscheiden und gegeneinander durch den doppelbrechenden Effekt der Platten versetzt sind.

Der Plattenstapel 7 wirkt auf gleiche Weise wie der Plattenstapel 6, so daß im an der Plattenstapeleinheit 2 austretenden Strahlbündel 11 ein gemischtes Strahlbündel 8b vorliegt, das aus rasterartigen Zellen besteht, die jeweils ein Teilstrahlbündel enthalten, welches aus unterschiedlich polarisierten Anteilen, die zueinander versetzt sind oder in unterschiedliche Richtungen propagieren, aufgebaut ist. Die Teilstrahlbündel der Zellen sind dabei gegeneinander zusätzlich durch die unterschiedlichen Längen der Platten versetzt.

Dies führt dazu, daß die einheitliche Wellenfront W des einfallenden Strahlbündels 10 im austretenden Strahlbündel eine Vielzahl von Wellenfronten W1 - W5 zerlegt ist, wobei jede Zelle des durch die gekreuzten Plattenstapel 6, 7 gebildeten Rasters ihrerseits mindestens zwei unterschiedliche Wellenfronten für senkrecht zueinander liegende Polarisationsanteile enthält. Diese Anzahl kann je nach Ausgestaltung der Plattenstapel 6, 7 variieren, was anhand der Fig. 3 und Fig. 4 noch erläutert werden wird.

Das austretende Strahlbündel 11 mit den rasterartig angeordneten Teilstrahlbändeln (die ihrerseits noch einmal hinsichtlich ihrer Polarisationsrichtung unterteilt sind) wird dann mittels der 4f-Abbildungsoptik 3 auf das Mikrolinsenarray 4 abgebildet. Dazu umfaßt die 4f-Abbildungsoptik eine erste und eine zweite Linse 12, 13 die jeweils eine objekt- und bildseitige Brennweite f aufweisen. Der Abstand der ersten Linse 12 vom Austritt der Plattenstapeleinheit 2 beträgt jeweils f, und die beiden Linsen 12, 13 sind um 2f voneinander beabstandet.

Durch die 4f-Abbildungsoptik 3 (in Fig. 1 ist zur besseren Übersichtlichkeit nur der Strahlverlauf eines Teilstrahlbündels in der 4f-Abbildungsopik 3 eingezeichnet) werden die Mikrolinsen 9 mit dem an der Plattenstapeleinheit 2 austretenden Strahlbündel 11 derart bestrahlt, daß jede Zelle des durch die gekreuzt liegende Plattenstapel 6, 7 bewirkten Rasters genau eine Mikrolinse des Mikrolinsenarray 9 beaufschlagt. Es ist natürlich auch möglich, die 4f-Abbildungsoptik 5 wegzulassen und das Mikrolinsenarray 4 direkt zum austretenden Strahlbündel 11 zu führen.

Dadurch weist eine zu einem Zeitpunkt auf das Mikrolinsenarray 4 treffende Wellenfront eine verminderte Kohärenz auf, da diese Wellenfront aus unterschiedlichen Zellen, die zum einen nicht interferenzfähig und zum anderen selbst noch aus unterschiedlichen Teilstrahlbündeln aufgebaut sind, zusammengesetzt ist. Die Punktdichte in der Pupille einer Mikrolinse ist dadurch erhöht.

Die vom Mikrolinsenarray 4 ausgehenden Strahlbündel M1 bis M5 werden dann mittels der Kondensoroptik 5 auf ein Objektfeld 14, das bevorzugt im Abstand der Brennweite der Kondensoroptik 5 von dieser beabstandet ist, so abgebildet, daß das Objektfeld 14 homogen ausgeleuchtet ist. Durch die Mischung des austretenden Strahlbündels 11 ist in Kombination mit dem Mikrolinsenarray 4 erreicht, das die Strahlbündel M1-M5 untereinander nicht interferieren, so daß keine störenden Speckle oder störende Interferenzen auftreten.

In einer Pupillenebene, die zwischen dem Mikrolinsenarray 4 und der Kondensoroptik 5 liegt, kann noch, wie aus der Mikroskopie an und für sich bekannt ist, eine verstellbare Blende (in Fig. 1 nicht gezeigt) vorgesehen werden, mit der die Helligkeit der Ausleuchtung des Objektfeldes 14 und das Winkelspektrum der auf das Objektfeld 14 treffenden Strahlung einstellbar ist.

Die im Kohärenzminderer 1 eingesetzte Plattenstapeleinheit 2 weist eine Vielzahl aus Platten mit doppelbrechendem Material auf. Die Wirkung dieses doppelbrechenden Materials ist beispielsweise in der DE 102 01 315 A1 erläutert; es wird diesbezüglich vollumfänglich auf die dortige Offenbarung verwiesen. Insbesondere ist dort beschrieben, daß ein linear polarisierter Strahl bei einer optischen Achse des doppelbrechenden Materials, die im Winkel von 45° zur Polarisationsrichtung liegt hinsichtlich einer Polarisationsrichtung phasenverzögert wird, so daß der Strahl nach Durchtritt durch das Material dann aus zwei gegeneinander verschobenen senkrecht zueinander polarisierten Strahlanteilen besteht. Bildet man das doppelbrechende Material, beispielsweise einen Kristall, mit planparallelen Grenzflächen aus, ist die Ausbreitungsrichtung beziehungsweise die optische Achse für die beiden Strahlteile nach dem Durchtritt durch das doppelbrechende Material gleich. Liegt dagegen die Ein- oder Austrittsfläche schräg zur optischen Achse, so treten die senkrecht zueinander polarisierten Teilstrahlen in unterschiedlichen Propagationsrichtungen aus. Diese beiden Effekte können nun jeweils eigenständig oder in Kombination bei den Plattenstapeln 6, 7 ausgenutzt werden.

Fig. 3 zeigt eine erste Ausführungsform mit einem planparallelen ersten Plattenstapel 6, d. h. die Platten 6a-c (zur Vereinfachung sind lediglich drei Platten pro Stapel gezeigt) liegen mit ihren Ein- und Austrittsflächen senkrecht zur optischen Achse. Beim zweiten Plattenstapel 7 (der zur Anschaulichkeit um 90° gedreht, d. h. in der gleichen Orientierung wie der Plattenstapel 6, eingezeichnet ist) sind dagegen die Austrittsflächen der Platten 7a-c in einem Keilwinkel, d.h. schräg zur optischen Achse orientiert.

In der Variante der Fig. 4 sind die Austrittsflächen beider Plattenstapel in einem Keilwinkel zur optischen Achse angeordnet, wobei der Keilwinkel zwischen den Platten eines Stapels variiert.

In der Variante der Fig. 4 hat somit sowohl die Austrittsfläche 24a-c jeder Platte 6a-c des ersten Plattenstapels 6, als auch die Austrittsfläche 27a-c jeder Platte 7a-c des zweiten Plattenstapels 7 eine schräg zur optischen Achse verlaufende Flächennormale. Dadurch laufen nach dem ersten Plattenstapel 6 die außerordentlichen und ordentlichen Teilstrahlen, die senkrecht zueinander polarisiert sind, beim Austritt aus der Platte in unterschiedliche Richtungen, so daß nach jeder Platte 6a-c Teilstrahlpaar 25a, 26a; 25b, 26b; 25c, 26c gegeben ist. Der Keilwinkel, d. h. der Winkel der Austrittsfläche ist dabei so gewählt, daß die Teitstrahlpaare nahezu auf den gleich Fleck der Eintrittsflächen der Plattenstapel 7a-c treffen, so daß sich nach Durchlauf durch den Plattenstapel 7 das oben erwähnte Raster der Teilstrahlen ergibt.

Die Eintrittsfläche des zweiten Plattenstapels 7 liegt vorzugsweise parallel zur Eintrittsfläche des ersten Plattenstapels. Die Orientierung der optisch aktiven Achse in der Eintrittsfläche der Platten 7a-c des zweiten Plattenstapels 7 ist in einer bevorzugten Ausgestaltung um 45° gegenüber der optisch aktiven Achse des ersten Plattenstapels 6 gedreht. Dadurch wird eine weitere Zerlegung der Teilstrahlpaare bezüglich dieser neuen Achse erreicht, so daß an der Austrittsfläche 27a-c jeder Platte 7a-c ein Teilstrahlquartett 28a, 29a, 30a, 31a; 28b, 29b, 30b, 31b; 28c, 29c, 30c, 31c erhalten wird. Die einzelnen Teilstrahlquartette sind bei geeigneter Wahl der Länge der Platten 6a-c und 7a-c der Plattenstapel 6 und 7 mindestens um eine zeitliche Kohärenzlänge voneinander getrennt, so daß keine Interferenz möglich ist. Dadurch verringert man die Speckleerscheinung. Eine Trennung um die doppelte zeitliche Kohärenzlänge schließt jede Interferenzfähigkeit grundsätzlich aus. Durch geeignete Wahl der Keilwinkel, insbesondere des zweiten Plattenstapels 7, läßt sich die Pupillenfüllung, die den Divergenzwinkeln in jedem Teilstrahlquartett entspricht, optimieren. Die Anzahl einer Mikrolinse zuzuordnenden Punkte in der Pupille wird durch diesen Aufbau vervierfacht, so daß jede Zelle, die einer Mikrolinse zugeordnet ist, insgesamt aus einem vierfach unterteilten Strahlbündel beleuchtet wird. Eine keilwinklige Ein- oder Austrittsfläche bei den Platten eines Plattenstapels führt zu einer Verdoppelung der Punktanzahl in der Pupille.

Ist die Orientierung der optischen Achse der Platten des zweiten Stapels 7 parallel zur optischen Achse des ersten Stapels 6 gewählt, erfolgt keine weitere räumliche Zerlegung in ordentlichen und außerordentlichen Teilstrahl. Die Strahlen durchlaufen die zweite Platte unter einem Winkel und treten unter einem Winkel auf. Die Anzahl der einer Mikrolinse 9 zu zuordneten Punkte in der Pupille wird durch diesen Aufbau verdoppelt. Allerdings wird die Interferenzfähigkeit weiter gemindert, da jedes Teilstrahlbündel aus zwei phasenverschobenen Polarisationsanteilen zusammengesetzt ist.

Ist die Rasterdichte der gekreuzten Plattenstapel 6, 7 gleich oder höher als die Dichte der Mikrolinse 9 des Mikrolinsenarrays 4, kann auf einfache Weise sichergestellt werden, daß in einer Pupille einer Mikrolinse 9 eine Vielzahl von Punkten liegt. Alternativ kann aber auch die Rasterdichte des Mikrolinsenarrays 4 dichter sein. Dann erfolgt eine weitere Unterteilung der durch die gekreuzten Plattenstapel 6, 7 bewirkten Zellen. Insbesondere können die wegen des Keitwinkels divergierenden Teilstrahlbündel in unterschiedliche Raster-Zellen des Mikrolinsenarrays 4 geführt werden.

Bei der Bauweise in Fig. 3 haben lediglich die Austrittsflächen 21a-c der Platten 7a-c des zweiten Plattenstapels 7 einen Keilwinkel. Bei Rotation der optisch aktiven Achse des ersten gegenüber der des zweiten Plattenstapels 6, 7 um 45° erfolgt damit eine Aufspaltung jedes Teilstrahls 20a-c, der vom ersten Plattenstapel 6 abgegeben wird. Die Teilstrahlbündel 20a-c im gemischten Strahlbündel 8b nach dem ersten Plattenstapel 6 sind für jede Platte 6a-c aus zwei senkrecht zueinander polarisierten Komponenten zusammengesetzt, die gegeneinander phasenverschoben sind. Dieses in sich verschobene Teilstrahlbündel wird nun durch die schräge Austrittsfläche 21a-c in jeweils ein divergierendes Teilstrahlbündelpaar 22a, 23a; 22b, 23b; 22c, 23c unterteilt. Durch die Verdrehung der optischen Achsen um 45° von erstem Plattenstapel 6 zu zweitem Plattenstapel 7 werden somit in der Pupille jeder Mikrolinse 9 zwei Punkte erzeugt, die jeweils einem Teilstrahlbündel zugeordnet sind, das zwei senkrecht zueinander polarisierte Komponenten mit Phasenversatz aufweist.

Wählt man dagegen die optische Achse des zweiten Plattenstapels 7 parallel zu derjenigen des ersten Plattenstapels 6, erfolgt keine weitere Zerlegung sondern Versatz der Polarisationsrichtungen. Die Dicke der Platten des zweiten Plattenstapels 7 sollten so gewählt werden, daß der optische Weglängenunterschied zwischen allen vier aus seinem Ursprungsstrahl hervorgegangen Teilstrahlbündein idealerweise der doppelten zeitlichen Kohärenzlänge entspricht.

Variiert man innerhalb eines Plattenstapels den Keilwinkel, erhält man eine ungeordnetere Ausleuchtung der Pupille jeder Mikrolinse, was die Homogenität der Objektfeldbeleuchtung noch erhöhen kann.

Bei der Dimensionierung der Platten der Plattenstapel soll vorzugsweise keine Abschattung zwischen den Platten auftreten und die Trennung der Lichtkanäle, d. h. der erwähnten Zellen des Rasters erhalten bleiben. Die Trennung der Lichtkanäle kann zusätzlich durch geeignete Maßnahmen beim Zusammenfügen der Stapel beeinflußt werden. So sind z.B. geeignete Beschichtungen möglich, die die Platten optisch trennen. Alternativ kann die Durchmischung zwischen den Lichtkanälen gefördert werden, wenn die Platten optisch vereinigt werden, z.B. durch Ansprengen.

## Patentansprüche

1. Kohärenzminderer der mindestens ein doppelbrechendes Element (2) aufweist, weiches ein zugeführtes, kohärentes Strahlbündel (10) in mehrere in senkrecht zueinander liegenden Polarisationsrichtungen polarisierte Teilstrahlbündel so aufteilt, daß die Teilstrahlbündel zueinander in Strahlrichtung und/oder quer zur Strahlrichtung versetzt sind und/oder in unterschiedliche Richtungen propagieren, **dadurch gekennzeichnet, daß** das doppelbrechende Element (2) einen Stapel (6, 7) aus doppelbrechenden Platten (6a-e, 7a-e) aufweist, wobei die Schmalseiten der Platten als Eintritts- bzw. Austrittsflächen dienen und wobei die Platten (6, 7) optisch unterschiedlich lang sind und jeweils nur von einem der Teilstrahlbündel durchsetzt sind, so daß die einzelnen Teilstrahlbündel optisch unterschiedlich lange Wege beim Passieren der Platten des Stapels durchlaufen.

2. Kohärenzminderer nach Anspruch 1, **dadurch gekennzeichnet, daß** zwei zueinander gekreuzte Stapel (6, 7) aus doppelbrechenden Platten (6a-c, 7a-c) vorgesehen sind, so daß in der Durchsicht ein Raster (11) entsteht.

3. Kohärenzininderer nach Anspruch 2, **dadurch gekennzeichnet, daß** den Stapeln (6, 7) ein Mikrolinsenarray (4) nachgeordnet ist, das Optikelemente (9) in einer zum Raster passenden Anordnung aufweist.

4. Kohärenzminderer nach Anspruch 3, **gekennzeichnet durch** eine Beleuchtungsoptik (5), die die vom Mikrolinsenarray (4) ausgehenden Strahlbündel zur homogenen Ausleuchtung eines Objektfeldes (14) abbildet.

5. Kohärenzminderer nach einem der obigen Ansprüche, **dadurch gekennzeichnet, daß** die Austrittsflächen (21a-c, 24a-c) der Platten (6a-c, 7a-c) mindestens eines Stapels (6, 7) in einem Keilwinkel zur optischen Achse (20a-c) liegen.

6. Kohärenzminderer nach Anspruch 5, **dadurch gekennzeichnet, daß** die Keilwinkel der Platten (6a-c, 7a-c) eines Stapels (6, 7) variieren.

7. Kohärenzminderer nach einem der Ansprüche 2 bis 5, **dadurch gekennzeichnet, daß** die optisch aktiven Achsen der Stapel (6, 7) gegeneinander verdreht sind, vorzugsweise um 45°.

8. Kohärenzminderer nach einem der obigen Ansprüche, **gekennzeichnet durch** eine Lichtquelle, welche die zugeführte kohörente Strahlung (10) aussendet und **dadurch**, daß die optische Weglängendifferenz in einem Stapel (6, 7) benachbarter Platten (6a-e, 7a-e) größer oder gleich der zeitlichen Kohärenzlänge der zugeführten Strahlung (10) ist.

9. Kohärenzminderer nach den Ansprüchen 3 und 8, **dadurch gekennzeichnet, daß** die Teilstrahlbündel (11) so zueinander versetzt sind, daß für jedes Teilstrahlbündel die innerhalb der räumlichen Kohärenzlänge benachbarten Teilstrahlbündel eine optische Weglängendifferenz durchliefen, die größer oder gleich der zeitlichen Kohärenzlänge ist.

10. Kohärenzminderer nach einem der obigen Ansprüche, **gekennzeichnet durch** Mittel zum gegenseitigen optischen Verbinden der Platten in einem Stapel (6, 7).

11. Kohärenzminderer nach einem der Ansprüche 1 bis 9, **gekennzeichnet durch** Mittel zum gegenseitigen optischen Trennen der Platten in einem Stapel (6, 7).

12. Kohärenzminderer nach Anspruch 2, **dadurch gekennzeichnet, daß** das Raster gleich oder dichter einen Raster nachfolgender die Teilstrahlbündel weiterleitender Homogenisierungselemente ist.

13. Kohärenzminderer nach Anspruch 12, **dadurch gekennzeichnet, daß** die Homogenisierungselemente einen Stufenspiegel, ein Faserbündelarray oder ein Mikrolinsenarray aufweisen.

## Claims

1. A coherence-reducing device, comprising at least one birefringent element (2) which splits up a supplied, coherent ray bundle (10) into a plurality of partial ray bundles, which are polarised in mutually orthogonal polarisation directions, such that the partial ray bundles are offset relative to each other in the beam direction and/or transverse to the beam direction and/or propagate in different directions, **characterised in that** the birefringent element (2) comprises a stack (6, 7) of birefringent plates (6a-e, 7a-e), wherein the narrow sides of the plates serve as entrance and exit surfaces, respectively, the plates (6, 7) have different optical lengths and are each traversed by only one of the partial ray bundles, so that the individual partial ray bundles travel paths of different optical lengths while passing the plates of the stack.

2. Coherence-reducing device according to claim 1, **characterised in that** two mutually crossed stacks (6, 7) of birefringent plates (6a-c, 7a-c) are provided so that, in a direct view, a raster (11) is produced.

3. Coherence-reducing device according to claim 2, **characterised in that** a microlens array (4) is arranged following the stacks (6, 7), said microlens array comprising optical elements (9) in an arrangement matching said raster.

4. Coherence-reducing device according to claim 3, **characterised by** illumination optics (5), which image the ray bundles coming from the microlens array (4) for homogeneous illumination of an object field (14).

5. Coherence-reducing device according to any one of the above claims, **characterised in that** the exit surfaces (21a-c, 24a-c) of the plates (6a-c, 7a-c) of at least one stack (6, 7) are located at a wedge angle to the optical axes (20a-c).

6. Coherence-reducing device according to claim 5, **characterised in that** the wedge angles of the plates (6a-c, 7a-c) of a given stack (6, 7) vary.

7. Coherence-reducing device according to any one of claims 2 to 5, **characterised in that** the optically active axes of the stacks (6, 7) are rotated relative to each other, preferably by 45°.

8. Coherence-reducing device according to any one of the above claims, **characterised by** a light source, which emits the supplied coherent radiation (10), and **characterised in that** the optical path length difference in a stack (6, 7) of adjacent plates (6a-e, 7a-e) is greater than or equal to the temporal coherence length of the supplied radiation (10).

9. Coherence-reducing device according to claims 3 and 8, **characterised in that** the partial ray bundles (11) are offset relative to each other such that, for each partial ray bundle, the partial ray bundles which are adjacent within the spatial coherence length passed through an optical path length difference which is greater than or equal to the temporal coherence length.

10. Coherence-reducing device according to any one of the above claims, **characterised by** means for mutual optical connection of the plates in a stack (6, 7).

11. Coherence-reducing device according to any one of claims 1 to 9, **characterised by** means for mutual optical separation of the plates in a stack (6, 7).

12. Coherence-reducing device according to claim 2, **characterised in that** the raster is equal to or more dense than a raster of subsequent homogenising elements passing said partial ray bundles on.

13. Coherence-reducing device according to claim 12, **characterised in that** the homogenising elements comprise a stepped mirror, a fibre bundle array or a microlens array.

## Revendications

1. Réducteur de cohérence qui présente au moins un élément (2) biréfringent, qui divise un faisceau de rayons (10) cohérent et amené en plusieurs faisceaux de rayons partiels polarisés dans des directions de polarisation perpendiculaires entre elles de telle sorte que les faisceaux de rayons partiels sont décalés les uns par rapport aux autres dans la direction du rayon et/ou transversalement à cette direction et/ou se propagent dans différentes directions, **caractérisé en ce que** l'élément (2) biréfringent présente une pile (6, 7) constituée de plaques (6a-e, 7a-e) biréfringentes, les côtés étroits des plaques servant de surfaces d'entrée ou de sortie, les plaques (6, 7) présentant une longueur différente au plan optique et étant traversées respectivement seulement par l'un des faisceaux de rayons partiels, de sorte que les faisceaux de rayons partiels individuels parcourent des trajets de longueurs différentes au plan optique lors du passage des plaques de la pile.

2. Réducteur de cohérence selon la revendication 1, **caractérisé en ce que** deux piles (6, 7) croisées l'une par rapport à l'autre et constituées de plaques (6a-c, 7a-c) biréfringentes sont prévues, de sorte qu'une trame (11) se forme en vue par transparence.

3. Réducteur de cohérence selon la revendication 2, **caractérisé en ce qu'**un agencement de microlentilles (4), qui présente des éléments d'optique (9) dans une disposition adaptée à la trame, est disposé en aval des piles (6, 7).

4. Réducteur de cohérence selon la revendication 3, **caractérisé par** une optique d'éclairage (5), qui reproduit le faisceau de rayons sortant de l'agencement de microlentilles (4) pour l'éclairage homogène d'un champ d'objet (14).

5. Réducteur de cohérence selon l'une quelconque des revendications précédentes, **caractérisé en ce que** les surfaces de sortie (21a-c, 24a-c) des plaques (6a-c, 7a-c) d'au moins une pile (6, 7) sont disposées dans un angle de coin par rapport à l'axe optique (20a-c).

6. Réducteur de cohérence selon la revendication 5, **caractérisé en ce que** les angles de coin des plaques (6a-c, 7a-c) d'une pile (6, 7) varient.

7. Réducteur de cohérence selon l'une quelconque des revendications 2 à 5, **caractérisé en ce que** les axes optiquement actifs des piles (6, 7) sont tournés les uns par rapport aux autres, de préférence de 45°.

8. Réducteur de cohérence selon l'une quelconque des revendications précédentes, **caractérisé par** une source lumineuse qui envoie le rayonnement cohérent (10) amené et par le fait que la différence de longueur de trajet optique dans une pile (6, 7) de plaques (6a-e, 7a-e) voisines est plus grande ou égale à la longueur de cohérence dans le temps du rayonnement (10) amené.

9. Réducteur de cohérence selon la revendication 3 et 8, **caractérisé en ce que** les faisceaux de rayons partiels (11) sont décalés les uns par rapport aux autres de telle sorte que, pour chaque faisceau de rayons partiel, les faisceaux de rayons partiels voisins à l'intérieur de la longueur de cohérence dans l'espace ont parcouru une différence de longueur de trajet optique qui est supérieure ou égale à la longueur de cohérence dans le temps.

10. Réducteur de cohérence selon l'une quelconque des revendications précédentes, **caractérisé par** des moyens pour la liaison optique réciproque des plaques dans une pile (6, 7).

11. Réducteur de cohérence selon l'une quelconque des revendications 1 à 9, **caractérisé par** des moyens pour la séparation optique réciproque des plaques dans une pile (6, 7).

12. Réducteur de cohérence selon la revendication 2, **caractérisé en ce que** la trame est égale ou plus dense qu'une trame d'éléments d'homogénéisation consécutifs qui transmettent les faisceaux de rayons partiels.

13. Réducteur de cohérence selon la revendication 12, **caractérisé en ce que** les éléments d'homogénéisation présentent un miroir à niveaux, un agencement de faisceau fibres ou un agencement de microlentilles.
